# EUROPÄISCHE PATENTSCHRIFT

(11) **EP 2 936 069 B1**
(45) Veröffentlichungstag und Bekanntmachung des Hinweises auf die Patenterteilung: **18.04.2018**
(21) Anmeldenummer: 13815456.2
(22) Anmeldetag: 17.12.2013
(51) Int. Cl.: G01P 3/487, G01D 5/12, G01R 33/00, G01D 5/14, G01D 11/24

(54) **SENSOR ZUM AUSGEBEN EINES ELEKTRISCHEN SIGNALS**
SENSOR FOR EMITTING AN ELECTRICAL SIGNAL
CAPTEUR PERMETTANT D'ÉMETTRE UN SIGNAL ÉLECTRIQUE

(30) Priorität: 20.12.2012 DE 102012224108; 20.09.2013 DE 102013219017
(43) Veröffentlichungstag der Anmeldung: 28.10.2015
(73) Patentinhaber: Continental Teves AG & Co. OHG, 60488 Frankfurt (DE)
(72) Erfinder: HILGENBERG, Udo, 60439 Frankfurt am Main (DE); RISCH, Stephan, 64331 Weiterstadt (DE); BOLDIZSAR, Laszlo, H-8200 Veszprem (HU); STÄHLIN, Ulrich, 65760 Eschborn (DE)
(86) Internationale Anmeldenummer: PCT/EP2013/076867
(87) Internationale Veröffentlichungsnummer: WO 2014/095835

(56) Entgegenhaltungen:
- EP-A2- 1 729 093
- WO-A1-2008/099749
- DE-C1- 19 733 719
- US-A1- 2010 321 006

## Beschreibung

Die Erfindung betrifft einen Sensor zum Ausgeben eines elektrischen Signals basierend auf einem zu erfassenden Weg, insbesondere eines Winkels.

Aus der WO 2006 / 029 946 A1 ist ein Winkelsensor mit einem Gebermagneten und einer Messschaltung mit einer Auswerteelektronik zur Auswertung einer Winkelposition des Gebermagneten bekannt. Der Gebermagnet weist keine direkte mechanische Verbindung zur Messschaltung auf, so dass der Gebermagnet aus Sicht der Auswerteelektronik über der Messschaltung schwebt.

Die Dokumente WO 2008/099749 A1, EP 1 729 093 A2 sowie DE 197 33 719 C1 offenbaren ähnliche Sensoren.

Es ist Aufgabe der Erfindung, den bekannten Winkelsensor zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Sensor zum Ausgeben eines elektrischen Signals basierend auf einem zu erfassenden Weg ein Gehäuse, das einen Innenraum und einen Außenraum abgrenzt, einen das Gehäuse vom Außenraum in den Innenraum durchdringenden Geber mit einem Wegaufnahmeelement im Außenraum und ein Feldgeberelement im Innenraum, wobei das Wegaufnahmeelement eingerichtet ist, das Feldgeberelement basierend auf dem zu erfassenden Weg gegenüber dem Gehäuse zu drehen, eine Auswerteschaltung zum Erfassen eines durch das Feldgeberelement abgegebenen physikalischen Feldes, und ein Feuchtigkeitsschutzelement zum Schützen eines Spaltes zwischen dem Gehäuse und dem Geber vor eindringender Feuchtigkeit.

Dem angegebenen Sensor liegt die Überlegung zugrunde, dass dieser an einem Fahrzeug zur Erfassung einer relativen Position eines Rades des Fahrzeuges zu seinem Chassis verwendet werden könnte. Auf diese Weise könnte ein aktives Fahrwerkregelsystem realisiert werden, mit dem der klassische Zielkonflikt zwischen sportlicher und komfortabler Fahrwerksabstimmung weiter aufgelöst werden könnte.

Hier zeigt sich jedoch, dass derartige Sensoren sehr fehleranfällig sind und damit eine vergleichsweise kurze Lebensdauer aufweisen. Im Rahmen des angegebenen Sensors wird dabei erkannt, dass eine Hauptursache für die kurze Lebensdauer in den Sensor eindringende Feuchtigkeit ist, die Auswerteschaltung des Sensors beschädigt und funktionsuntüchtig macht. Diese eintretende Feuchtigkeit ist der Ursache geschuldet, dass der Sensor an der Fahrzeugunterseite angebracht direkt von der Straße aufgewirbeltem Schmutz und Feuchtigkeit ausgesetzt ist.

Daher liegt dem angegebenen Sensor die Idee zugrunde diesen und insbesondere seine Auswerteschaltung durch ein Feuchtigkeitsschutzelement vor eindringender Feuchtigkeit zu schützen.

Das Feuchtigkeitsschutzelement kann beliebig ausgebildet sein. In besonders günstiger Weise umfasst das Feuchtigkeitsschutzelement ein Labyrinth, das eingerichtet ist, einen Fließweg der eindringenden Feuchtigkeit im Spalt zu verlängern. Ein derartiges Labyrinth lässt sich durch einfache geometrische Änderungen am Gehäuse und/oder Geber umsetzen und erfordert daher prinzipiell keine neuen Elemente, so dass das Feuchtigkeitsschutzelement in dem angegebenen Sensor kostenneutral realisieren ließe. Das Labyrinth ist aus einer am Geber ausgebildeten ersten Hülse und einer am Gehäuse ausgebildeten zweiten Hülse ausgebildet, die ineinander eingreifen. Zwei derartige Hülsen würden den oben genannten Spalt zwischen dem Gehäuse und dem Geber axial verlängern so dass der Eintritt der eindringenden Feuchtigkeit in den Innenraum stark verzögert wird. Der angegebene Sensor umfasst ein Bypass-Element, das eingerichtet ist, die eindringende Feuchtigkeit an dem Spalt vorbeizuleiten. Auf diese Weise könnte die Vermeidung des Eindringens der Feuchtigkeit weiter verbessert werden. Das Bypass-Element ist eine in wenigstens einer der beiden Hülsen ausgebildete Drainagerinne. Diese Drainagerinne lässt sich kostenneutral durch einfache geometrische Veränderungen an den Hülsen ausbilden, ohne dass zusätzliche technische Elemente notwendig werden. Die Drainagerinne kann das Wasser beispielsweise umfänglich am Spalt vorbeileiten, wobei das Wasser dann aus der Drainagerinne unterhalb des Spaltes herunterfallen würde, ohne in diesen einzudringen. Die entsprechend andere Hülse weist einen in die Drainagerinne eingreifenden Vorsprung auf. Auf diese Weise wird der zuvor genannte Spalt noch weiter verlängert und so die Labyrinth-Wirkung weiter verstärkt.

Um die Labyrinth-Wirkung noch weiter zu verstärken, kann wenigstens eine der beiden Hülsen, vorzugsweise aber beide Buchen je in eine umlaufende Nut eingreifen, die entsprechend am Gehäuse und/oder am Geber ausgebildet ist.

In einer noch anderen Weiterbildung des angegebenen Sensors ist das Gehäuse und/oder der Geber konisch einem Eintrittspunkt des Spaltes weglaufend ausgebildet. Auf diese Weise wird die Menge an Feuchtigkeit, die überhaupt in den Spalt potentiell eintreten kann, reduziert.

Besonders bevorzugt ist der konische Verlauf dabei innenseitig und außenseitig ausgebildet, so dass, innseitig in den Spalt eingetretene Feuchtigkeit wieder zurück zum Spalt geleitet wird.

Gemäß einem weiteren Aspekt der Erfindung umfasst ein Fahrzeug einen der angegebenen Sensoren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 in einer schematischen Ansicht ein Fahrzeug mit einem Fahrwerksregelsystem,
Fig. 2 einen Teil eines CPS Sensors,
Fig. 3 einen Teil eines alternativen CPS Sensors,
Fig. 4 einen Teil eines weiteren alternativen CPS Sensors, und
Fig. 5 einen Teil eines noch anderen CPS Sensors zeigen.

In den Figuren werden gleiche technische Elemente mit gleichen Bezugszeichen versehen und nur einmal beschrieben.

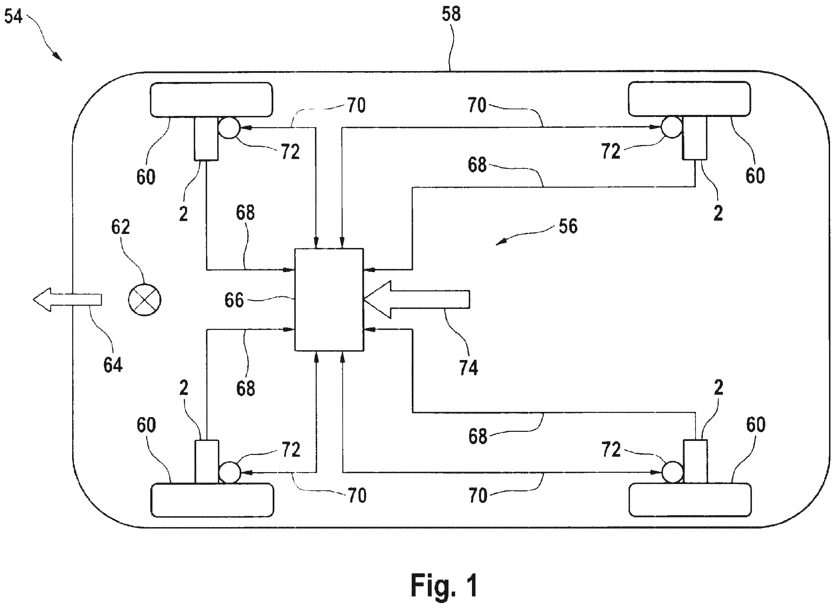

Es wird auf Fig. 1 Bezug genommen, die in einer schematischen Ansicht ein Fahrzeug 54 mit einem Fahrwerksregelsystem 56 zeigt.

Im Rahmen dieses Fahrwerksregelsystem 56 sollen Hub-, Nick und Wankbewegungen eines Chassis 58 gegenüber einer nicht weiter dargestellten Straße, auf der ortsfest Räder 60 des Fahrzeuges 54 in einer Hochachse 62 ortsfest rollen minimiert werden, um die Fahreigenschaften des Fahrzeuges 54 beim Fahren in einer Fahrtrichtung 64 zu verbessern.

Dazu weist das Fahrwerksregelsystem in einer beispielsweise aus der DE 10 2005 060 173 A1 bekannten Weise eine Steuervorrichtung 66 auf, die in der vorliegenden Ausführung aus an jedem Rad 60 angeordneten Winkelsensoren 2 Drehwinkel 68 empfängt, die eine relative Lage des entsprechenden Rades 60 gegenüber dem Chassis 58 beschreiben. Basierend auf den Differenzen dieser Drehwinkel 68 bestimmt die Steuervorrichtung 66, ob das Chassis 58 sich in der Hochachse 62 bewegt, also eine Hubbewegung ausführt, oder ob das Chassis 58 wankt oder nickt und steuert. In diesem Fall berechnet die Steuervorrichtung 66 eine dieser Hub-, Wank- und/oder Nickbewegung entgegenwirkenden Gegenbewegung und steuert mit geeigneten Steuersignalen 70 an den Rädern 60 angeordnete aktive Federbeine 72 an, um mit dem Chassis 6 diese Gegenbewegung auszugleichen. Als aktive Federbeine 72 können beispielsweise die aus der DE 101 22 542 B4 bekannten Federbeine verwendet werden.

Um durch die Straßenlage bedingte Hub-, Wank- und/oder Nickbewegungen beispielsweise bei einer Kurvenfahrt zu berücksichtigen, kann der Steuervorrichtung ein geeigneter Sollwert 74 zugeführt werden.

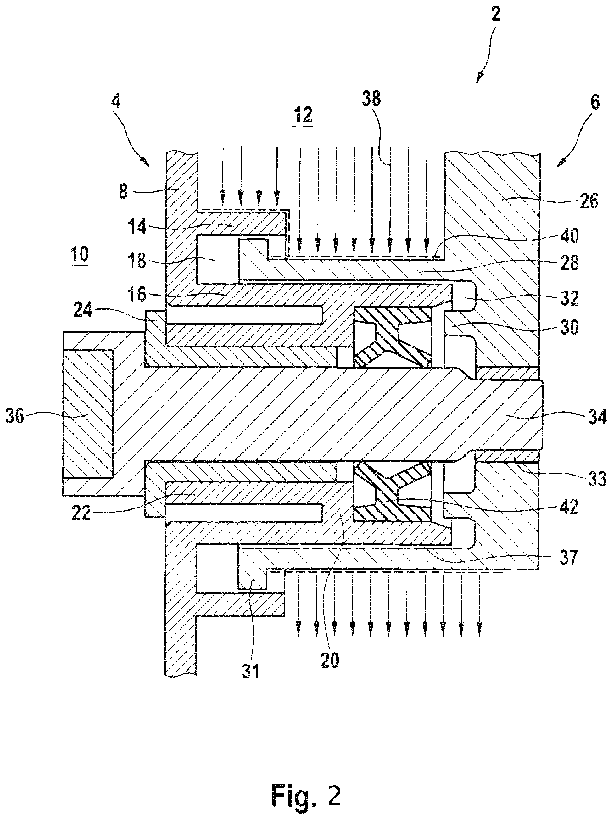

Die Winkelsensoren 2 sind in der vorliegenden Ausführung als Chassis Position Sensoren 2, nachstehend CPS Sensoren 2 genannt ausgeführt. Der Chassis Position Sensor misst eine relative Lage des Chassis 58 des Fahrzeuges 2 gegenüber seinem Fahrwerk oder einem der Räder 60 misst. Einer dieser
CPS Sensoren 2 soll nachstehend anhand der Figuren 2 bis 5 näher beschrieben werden.

In Fig. 2 ist eine Ausführung des CPS Sensors 2 dargestellt.

Der CPS Sensor 2 umfasst ein Gehäuse 4, das beispielsweise ortsfest mit dem Chassis 58 des Fahrzeuges 54 verbindbar ist, und einen Geber 6, der oben genannte relative Lage des Fahrwerkes oder Rades 60 des Fahrzeuges 54 gegenüber dem Chassis 58 und damit dem Gehäuse 4 erfasst. Dazu ist der Geber 6 drehbar gegenüber dem Gehäuse 4 gelagert.

Das Gehäuse 4 umfasst eine Gehäusewand 8, die einen Innenraum 10, in dem eine nicht weiter dargestellte Auswerteschaltung aufgenommen ist, von einem Außenraum 12 trennt.

Von dieser Gehäusewand ragen ferner axial eine erste Gehäusehülse 14 und eine konzentrisch dazu angeordnete zweite Gehäusehülse 16 ab, die gemeinsam eine radial dazwischenliegende Gehäusenut 18 ausbilden. Ferner ragt von der ersten Gehäusehülse 14 konzentrisch nach innen ein
Gehäuseflansch 20 ab, von an den sich an seiner radialen Innenseite eine dritte Gehäusehülse 22 anschließt. In dieser dritten Gehäusehülse 22 ist ein beispielsweise als Gleitlager ausgeführtes Drehlager 24 gehalten.

Der Geber 6 umfasst einen in Fig. 2 abgeschnitten dargestellten Hebel 26, der beispielsweise durch das Rad 60 bewegt und so gegenüber dem Gehäuse 4 gedreht werden kann. Vom Hebel 26 ragen axial eine erste Geberhülse 28 und eine konzentrisch dazu angeordnete zweite Geberhülse 30 ab, die radial zwischen sich eine Gebernut 32 ausbilden. Dabei ist am dem Hebel 26 axial gegenüberliegenden Ende der ersten Geberhülse 28 eine Geberwulst 31 ausgebildet. Konzentrisch innerhalb der beiden Geberhülsen 28, 30 ist eine Buchse 33 angeordnet, in der eine Welle 34 mittels Presspassung gehalten ist. Am dem Hebel axial gegenüber liegenden Ende der Welle ist ein Feldgeberelement in Form eines Magneten 36 ortsfest zur Welle 34 gehalten.

Durch den zuvor genannten Aufbau kann der Magnet 36 über die Welle 34 mit dem Hebel 26 gegenüber dem ortsfest zum Chassis des Fahrzeuges angeordneten Gehäuse 4 gedreht werden. Dabei sind das Gehäuse 4 und der Geber 6 derart axial zueinander angeordnet, dass die erste Geberhülse 28 in die Gehäusenut 18 und die zweite Gehäusehülse 14 in die Gebernut 32 axial eingreifen, so dass sich ein labrintartiger Spalt 37 zwischen dem Gehäuse 4 und dem Geber 6 ausbildet. Die Welle 34 führt dabei die Bewegung des im Außenraum 12 angeordneten Hebels 26 in den Innenraum 10 zum Magneten 36. Dieser gibt ein sich in Abhängigkeit der Lage des Hebels 26 und somit des Magneten 36 änderndes physikalisches Feld in Form eines Magnetfeldes ab, dass von der nicht weiter dargestellten Auswerteschaltung erfasst und beispielsweise zur Bestimmung der relativen Lage in einer an sich bekannten Weise ausgewertet wird.

Der CPS Sensor 2 muss zur Erfassung der relativen Lage des Fahrwerks zum Chassis in unvorteilhafter Weise an einer Unterbodenseite des Fahrzeuges angeordnet werden, an der es vergleichsweise viel eindringender Feuchtigkeit 38 ausgesetzt ist. Würde diese Feuchtigkeit 38 in den Innenraum 10 des Gehäuses 4 eindringen, so könnte es die nicht weiter dargestellte Auswerteschaltung schädigen und den CPS Sensor 2 funktionsunfähig machen. Aus diesem Grund ist der labyrintartige Spalt 37 ausgebildet, der den Weg für die Feuchtigkeit 38 erhöht und so die Zeit, bis die Feuchtigkeit die Auswerteschaltung erreichen kann verlängert.

Ferner bildet die Geberwulst 31 zusammen mit dem Hebel 26 und der ersten Geberhülse 28 ein weiteres als Bypass ausgeformtes Feuchtigkeitsschutzelement aus. Dieser ist als an der radialen Außenseite der Geberhülse 28 verlaufende Drainagerinne 40 ausgebildet, die die von der Außenseite 12 eindringende Feuchtigkeit auffängt und an der radialen Außenseite der Geberhülse 28 umfänglich um die Welle 34 an dem labyrinthartigen Spalt 37 vorbeiführt, so dass die Feuchtigkeit erst gar nicht in diesen eindringen kann.

Als noch weiteres Feuchtigkeitsschutzelement kann in der vorliegenden Ausführung eine Dichtung in Form einer Y-Dichtung 42 radial zwischen der Welle 34 und der zweiten Gehäusehülse 14 angeordnet sein, die den Innenraum 10 des Gehäuses 4 gegenüber der eindringenden Feuchtigkeit physikalisch abdichtet.

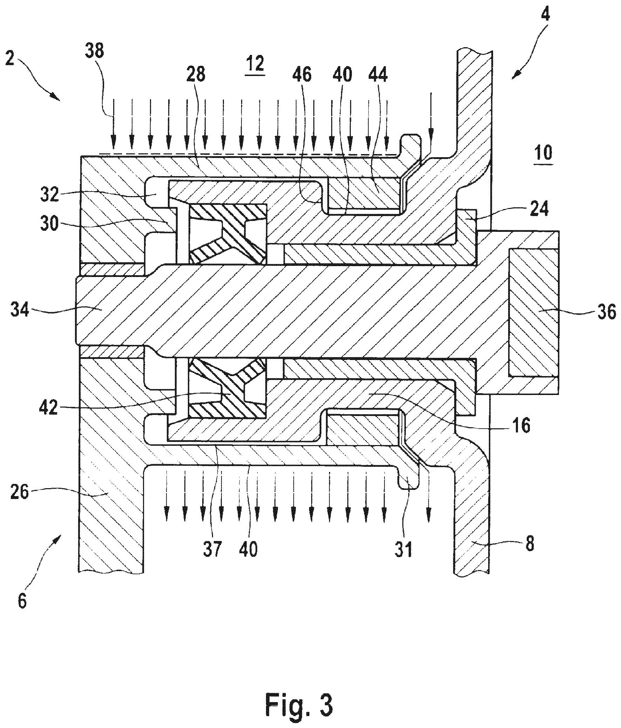

In Fig. 3 ist ein Teil eines alternativen CPS Sensors 2 dargestellt. Dieser alternative CPS Sensor 2 umfasst nur noch die zweite Gehäusehülse 16 und die erste Geberhülse 28, zwischen denen der labyrinthartige Spalt 37 ausgebildet ist. Dafür ist in der zweiten Geberhülse 16 eine weitere Drainagerinne 40 ausgebildet, in die in der vorliegenden Ausführung radial ein Vorsprung 44 ein. Dieser Vorsprung 44 macht zwar einen aufwändig herzustellenden Hinterschnitt 46 notwendig, dennoch wird durch den Vorsprung 44 der labyrinthartige Spalt 37 weiter vergrößert.

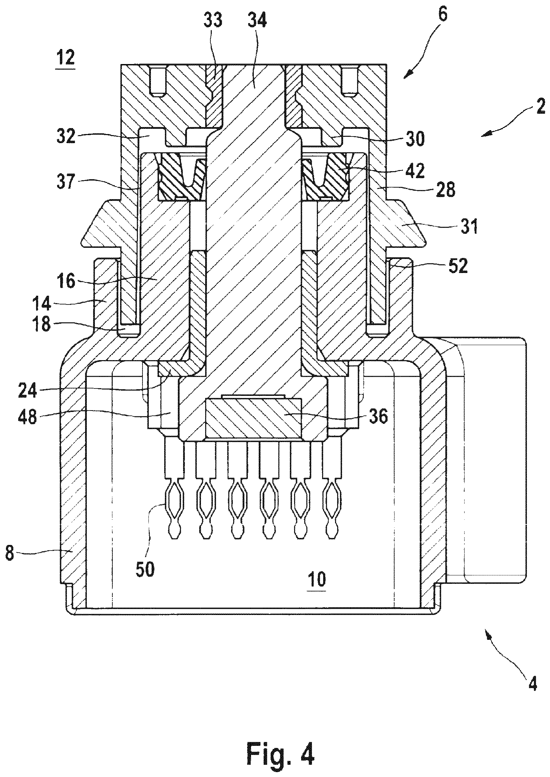

In Fig. 4 ist einen Teil eines weiteren alternativen CPS Sensors 2 gezeigt. In Fig. 4 ist der Hebel 26 am Geber nicht zu sehen. Dafür aber ist in Fig. 4 die Auswerteschaltung zu sehen, die mit dem Bezugszeichen 48 versehen ist. Von dieser Auswerteschaltung 48 ragen elektrische Kontakte in Form von sogenannten PressFits 50 ab, über die die Auswerteschaltung 48 an eine übergeordnete Steuereinrichtung, wie beispielsweise eine Motorsteuerung des Fahrzeuges angeschlossen werden kann. Von diesen PressFits 50 ist in Fig. 4 nur einer mit einem Bezugszeichen versehen.

In Fig. 4 ist die Geberwulst 31 konisch ausgebildet und überdacht einen Eingang 52 des labyrinthartigen Spaltes 37. Auf diese Weise wird die Möglichkeit für in den labyrinthartigen Spalt 37 eindringende Feuchtigkeit weiter reduziert.

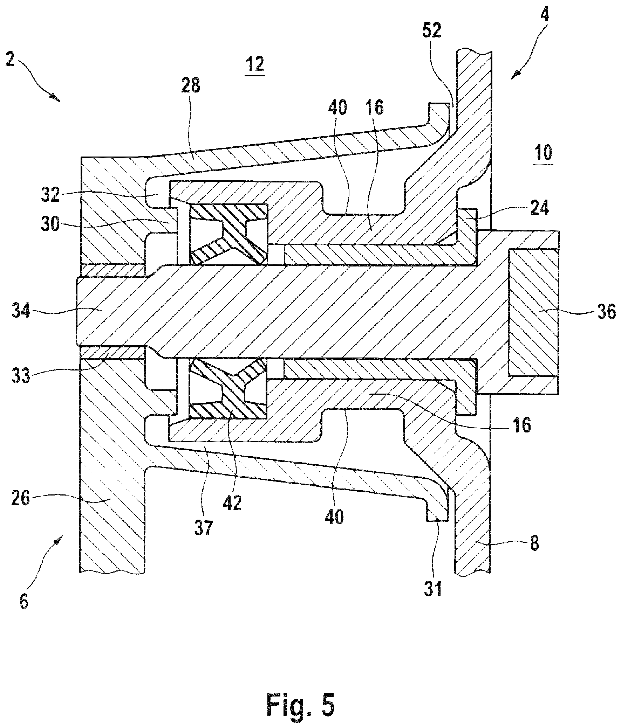

In Fig. 5 ist ein Teil eines noch anderen CPS Sensors 2 dargestellt. In diesem CPS Sensor 2 ist die erste Geberhülse 28 vom Eintrittspunkt 52 des labyrinthartigen Spaltes 37 aus zum Hebel 26 hin konisch zulaufend ausgebildet. Diese konische Form ist dabei innerhalb des Spaltes 37 als auch zum Außenraum 12 hin ausgebildet, so dass Feuchtigkeit am Außenraum vom Eintrittspunkt 52 des labyrinthartigen Spaltes 37 weggeleitet und innerhalb des labyrintartigen Spaltes 38 zum Eintrittspunkt 52 hingeleitet wird.

## Patentansprüche

1. Sensor (2) zum Ausgeben eines elektrischen Signals basierend auf einem zu erfassenden Weg, umfassend
- ein Gehäuse (4), das einen Innenraum (10) und einen Außenraum (12) abgrenzt,
- ein das Gehäuse (4) vom Außenraum (12) in den Innenraum (10) durchdringender Geber (6) mit einem Wegaufnahmeelement (26) im Außenraum (12) und ein Feldgeberelement (36) im Innenraum (10), wobei das Wegaufnahmeelement (26) eingerichtet ist, das Feldgeberelement (36) basierend auf dem zu erfassenden Weg gegenüber dem Gehäuse (4) zu drehen,
- eine Auswerteschaltung (48) zum Erfassen eines durch das Feldgeberelement (36) abgegebenen physikalischen Feldes,
- ein Feuchtigkeitsschutzelement (37, 40, 42) zum Schützen eines Spaltes zwischen dem Gehäuse (4) und dem Geber (6) vor eindringender Feuchtigkeit (38), und
- ein Bypass-Element (40), das eingerichtet ist, die eindringende Feuchtigkeit (38) an dem Spalt vorbeizuleiten,
- wobei das Feuchtigkeitsschutzelement (37, 40, 42) ein Labyrinth (37) umfasst, das eingerichtet ist, einen Fließweg der eindringenden Feuchtigkeit im Spalt zu verlängern
- wobei das Labyrinth (37) aus einer am Geber (6) ausgebildeten ersten Hülse (28) und einer am Gehäuse (4) ausgebildeten zweiten Hülse (16) ausgebildet ist, die ineinander eingreifen, und
- wobei das Bypass-Element (40) eine in wenigstens einer der beiden Hülsen (16, 28) ausgebildete Drainagerinne (40) ist,
**dadurch gekennzeichnet, dass** die entsprechend andere Hülse (28, 16) einen in die Drainagerinne (40) eingreifenden Vorsprung (44) aufweist.

2. Sensor (2) nach Anspruch 1, wobei wenigstens eine der Hülsen (16, 28) in eine umlaufende Nut (18, 32) eingreift, die entsprechend am Gehäuse (4) oder am Geber (6) ausgebildet.

3. Sensor (2) nach Anspruch 1, wobei das Gehäuse (4) und/oder der Geber (6) konisch von einem Eintrittspunkt des Spaltes (52) weglaufend ausgebildet sind.

4. Sensor (2) nach Anspruch 3, wobei der konische Verlauf innenseitig und außenseitig ausgebildet ist.

## Claims

1. Sensor (2) for emitting an electrical signal based on a travel to be detected, comprising
- a housing (4) which spans an interior space (10) and an exterior space (12),
- a signal generator (6) which penetrates the housing (4) from the exterior space (12) into the interior space (10) and which has a travel sensor element (26) in the exterior space (12) and a field signal generator element (36) in the interior space (10), wherein the travel sensor element (26) is configured to rotate the field signal generator element (36) with respect to the housing (4) on the basis of the travel to be detected,
- an evaluation circuit (48) for detecting a physical field which is output by the field signal generator element (36),
- a moisture protection element (37, 40, 42) for protecting a gap between the housing (4) and the signal generator (6) against penetrating moisture (38), and
- a bypass element (40) which is configured to conduct the penetrating moisture (38) past the gap,
- wherein the moisture protection element (37, 40, 42) comprises a labyrinth (37) which is configured to lengthen a flowpath of the penetrating moisture in the gap,
- wherein the labyrinth (37) is embodied from a first sleeve (28) which is embodied on the signal generator (6), and a second sleeve (16) which is embodied on the housing (4) and which engage one in the other, and
- wherein the bypass element (40) is a drainage channel (40) which is embodied in at least one of the two sleeves (16, 28),
**characterized in that** the corresponding other sleeve (28, 16) has a projection (44) which engages in the drainage channel (40).

2. Sensor (2) according to Claim 1, wherein at least one of the sleeves (16, 28) engages in a circumferential groove (18, 32) which is correspondingly embodied on the housing (4) or on the signal generator (6).

3. Sensor (2) according to Claim 1, wherein the housing (4) and/or the signal generator (6) are embodied conically running away from an inlet point of the gap (52) .

4. Sensor (2) according to Claim 3, wherein the conical profile is embodied on the inside and on the outside.

## Revendications

1. Capteur (2) destiné à délivrer un signal électrique sur la base d'un déplacement à détecter comprenant
- un boîtier (4) qui délimite un espace intérieur (10) et un espace extérieur (12),
- un détecteur (6) traversant le boîtier (4) de l'espace extérieur (12) vers l'espace intérieur (10), comportant un élément d'acquisition de déplacement (26) dans l'espace intérieur (12) et un élément générateur de champ (36) dans l'espace intérieur (10), dans lequel l'élément d'acquisition de déplacement (26) est conçu pour faire tourner l'élément générateur de champ (36) par rapport au boîtier (4) sur la base du déplacement à détecter,
- un circuit d'évaluation (48) destiné à détecter un champ physique délivré par l'élément générateur de champ (36),
- un élément de protection contre l'humidité (37, 40, 42) destiné à protéger une fente présente entre le boîtier (4) et le détecteur (6) contre l'humidité (38) y pénétrant, et
- un élément de dérivation (40) qui est conçu pour dévier l'humidité (38) ayant pénétré vers la fente,
- dans lequel l'élément de protection contre l'humidité (37, 40, 42) comprend un labyrinthe (37) qui est conçu pour augmenter la longueur du trajet d'écoulement de l'humidité pénétrant dans la fente,
- dans lequel le labyrinthe (37) est constitué d'un premier manchon (38) formé sur le détecteur (6) et d'un deuxième manchon (16) formé sur le boîtier (4), qui s'emboîtent l'un dans l'autre, et
- dans lequel l'élément de dérivation (40) est une rigole de drainage (40) réalisée dans au moins l'un des deux manchons (16, 28),
**caractérisé en ce que** l'autre manchon (28, 16) correspondant comporte une saillie (44) s'engageant dans la rigole de drainage (40).

2. Capteur (2) selon la revendication 1, dans lequel au moins l'un des manchons (16, 28) s'engage dans une encoche circonférentielle (18, 32) qui est réalisée de manière correspondante sur le boîtier (4) ou sur le détecteur (6).

3. Capteur (2) selon la revendication 1, dans lequel le boîtier (4) et/ou le détecteur (6) est/sont réalisé(s) de manière conique à partir d'un point d'entrée de la fente (52).

4. Capteur (2) selon la revendication 3, dans lequel l'étendue conique est réalisée du côté intérieur ou du côté extérieur.
